# EUROPÄISCHE PATENTSCHRIFT

(11) **EP 3 101 330 B1**
(45) Veröffentlichungstag und Bekanntmachung des Hinweises auf die Patenterteilung: **05.08.2020**
(21) Anmeldenummer: 16172538.7
(22) Anmeldetag: 01.06.2016
(51) Int. Cl.: F16P 3/14, B30B 1/00, H03K 17/94

(54) **GESENKBIEGEPRESSE UND VERFAHREN ZUR BETÄTIGUNG EINER GESENKBIEGEPRESSE**
PRESS BRAKE AND METHOD FOR ACTUATING A PRESS BRAKE
PRESSE DE PLIAGE ET PROCÉDÉ D'ACTIONNEMENT D'UNE PRESSE DE PLIAGE

(30) Priorität: 01.06.2015 EP 15170171
(43) Veröffentlichungstag der Anmeldung: 07.12.2016
(73) Patentinhaber: Bystronic Laser AG, 3362 Niederönz (CH)
(72) Erfinder: Foellmer, Rainer, 99869 Goldbach (DE)
(74) Vertreter: Schwarz und Baldus Patentanwälte

(56) Entgegenhaltungen:
- DE-U1-202010 017 961
- US-A- 3 805 085
- US-A- 4 305 006
- US-A- 5 077 467
- US-B1- 6 285 021
- US-E1- R E37 777

## Beschreibung

Die Erfindung betrifft eine Gesenkbiegepresse nach dem Oberbegriff des Anspruchs 1 sowie Verfahren zur Betätigung einer Gesenkbiegepresse nach dem Oberbegriff des Anspruchs 11 und des Anspruchs 14. Gesenkbiegepressen, auch Biegemaschinen oder Abkantpressen genannt, dienen der Umformung von Blechen und weisen üblicherweise eine Unterwange und eine Oberwange auf, wobei zumeist die Oberwange relativ zu der Unterwange verfahrbar ist. Die Hauptgefahrenzone beziehungsweise der Gefahrenbereich einer Gesenkbiegepresse sind die in der Unterwange und/oder in der Oberwange eingesetzten Werkzeuge und der damit verbundene Bereich sowie die in der Gesenkbiegepresse integrierten Zufuhr- und Entnahmevorrichtungen. Zur Sicherung des Gefahrenbereichs der Gesenkbiegepresse werden beispielsweise Lichtschranken als Schutzeinrichtung vorgesehen. Um den Arbeitshub auszulösen, muss ein Zustimmschalter betätigt werden. Nach der Ausführung des Arbeitshubs fährt die Oberwange wieder in eine Stellung, beabstandet zur Unterwange zurück, damit das bearbeitete Blech umpositioniert oder entnommen beziehungsweise ein neues Blech positioniert werden kann.

Aus der US3805085A ist eine gatungsgemässe Gesenkbiegepresse gemaß des Oberbegriffs des Anspruch 1 bekannt.

Aus der US4831862A ist eine gattungsgemässe Gesenkbiegepresse bekannt, bei der die Schutzwirkung der Schutzeinrichtung mittels eines von einem Bediener betätigbaren Zustimmschalters in Form eines Fusspedals überwindbar ist.

Nachteilig an der bekannten Lösung ist, dass der Bediener jeweils das Fusspedal suchen muss. Diese Suche gestaltet sich insbesondere bei Gesenkbiegepressen mit langen Biegelinien, grossflächigen Blechen oder bei Blechen mit komplexen Biegeformen oftmals als schwierig. Zudem wird das Betätigen von Fusspedalen, insbesondere über einen längeren Zeitraum, von Bedienern als ermüdend empfunden.

Aus der US5077467A ist ein von Hand betätigbarer, photoelektrischen Zustimmschalter für eine Maschine, wie eine Gesenkbiegepresse, bekannt, der eine Strahlenquelle und einen Strahlenempfänger umfasst. Sobald der Bediener mit seiner Hand die Strahlung zwischen der Strahlenquelle und dem Strahlenempfänger unterbricht, wird ein Relay bzw. die Maschine aktiviert.

Nachteilig an der bekannten Lösung ist, dass der Bediener an einer ortsfesten Position an der Gesenkbiegepresse den Zustimmschalter bedienen muss. Insbesondere bei Gesenkbiegepressen mit langen Biegelinien kann die Bedienung derselben mit einer solchen Art von Zustimmschalter sehr mühsam für den Bediener, wenn nicht gar unmöglich sein.

Aufgabe der vorliegenden Erfindung ist es somit, eine Gesenkbiegepresse zu schaffen, welche die vorgenannten Nachteile nicht aufweist und insbesondere flexibel, einfach sowie ermüdungsfrei zu bedienen ist.

Die Aufgabe wird durch die Merkmale der unabhängigen Ansprüche gelöst. Vorteilhafte Weiterbildungen sind in den Figuren und in den abhängigen Patentansprüchen dargelegt.

Gemäss der Erfindung verläuft die Strahlrichtung der Strahlenquelle des Zustimmschalters in eine Richtung entlang der Biegelinie der Gesenkbiegepresse.

Neben einer parallelen Ausrichtung der Strahlrichtung zur Biegelinie beziehungsweise einer Ausrichtung entlang der Biegelinie, kann diese ebenfalls leicht abgewinkelt zu dieser sein, womit eine ergonomisch einfach bedienbare Gesenkbiegepresse geschaffen wird.

Der Zustimmschalter ist durch Unterbrechen beziehungsweise durch Freigabe der Strahlung zwischen der Strahlenquelle und dem Strahlenempfänger betätigbar und somit einfach bedienbar. Zumindest der Strahlenempfänger ist vorteilhaft mit einer Auswerteschaltung verbunden, um eine Unterbrechung beziehungsweise eine Freigabe der Strahlung der Steuerung der Gesenkbiegepresse anzuzeigen.

Die Schutzeinrichtung, welche vorteilhaft mitfahrend ausgebildet ist, gewährleistet den Schutz vor Quetschen, insbesondere von Extremitäten eines Bedieners. Dabei ist diese Schutzeinrichtung bis zum sicheren Schliessen der in der Oberwange und der Unterwange angeordneten Werkzeuge aktiv. Somit wird eine weitere Unterbrechung von dieser Schutzeinrichtung während der Schliessbewegung, z. B. der Oberwange zu der Unterwange, erkannt und führt zum Stopp der Bewegung der Oberwange, wenn etwas in den Gefahrenbereich zwischen den Werkzeugen beziehungsweise zwischen der Oberwange und der Unterwange liegt beziehungsweise eindringt. Mittels des Zustimmschalters wird die Schutzeinrichtung übersteuert.

Die Strahlenquelle ist beispielsweise eine Quelle für elektromagnetische Strahlung und der Strahlenempfänger ist ein Detektor für elektromagnetische Strahlung, womit eine gezielte Ausrichtung der Strahlung zwischen der Strahlenquelle und dem Strahlenempfänger parallel zur beziehungsweise entlang der Biegelinie der Gesenkbiegepresse möglich und eine einfache Feststellung von Unterbrüchen oder Freigaben der Strahlung erkennbar ist.

Vorteilhaft ist die Strahlenquelle eine Lichtquelle, wobei neben für das menschliche Auge sichtbarem Licht auch für das menschliche Auge unsichtbares Licht zur Anwendung kommen kann. Derartige Strahlenquellen stehen in verschiedensten Ausführungen zur Verfügung und zeichnen sich durch eine hohe Gebrauchstauglichkeit wie auch Sicherheit aus.

Vorteilhaft wird ein Zustimmschalter mit einer Lichtquelle mit für das menschliche Auge unsichtbaren Licht angesehen, bei dem zusätzlich eine Lichtquelle mit für das menschliche Auge sichtbarem Licht vorhanden ist. Die Lichtquelle mit für das menschliche Auge sichtbarem Licht umfasst beispielsweise einen optischen Laser. Mit dem für das menschliche Auge sichtbaren Licht nimmt der Benutzer die Lage des Zustimmschalters visuell wahr, womit das Auffinden desselben für den Bediener einfach ist. Zudem ist ein solcher Zustimmschalter kostengünstig herstellbar beziehungsweise beschaffbar und daher wirtschaftlich vorteilhaft.

Beispielsweise ist der Strahlenempfänger eine Kamera oder ein CCD-Chip, vorzugsweise einzelne Fotodioden, wobei ein solcher Strahlenempfänger insbesondere mit einer Lichtquelle vorteilhaft ist. Mit einer Kamera lassen sich einfach und sicher Veränderungen der Strahlung erfassen und die Steuerung entsprechend anzupassen. Als strahlungsempfindlicher Chip kommt beispielsweise ein lichtempfindlicher Chip (z. B. CCD-Sensor) zur Anwendung, der kleinste Veränderungen der Strahlung erfassen kann.

Vorteilhaft sind die Strahlenquelle und der Strahlenempfänger Teil einer Lichtschranke oder eines Lichtgitters, womit bestehende und bewährte Lösungen zum Einsatz kommen.

Vorzugsweise sind die Strahlenquelle und der Strahlenempfänger an der Biegelinie der Gesenkbiegepresse angeordnet, so dass diese Biegelinie von der Strahlung zwischen diesen abgedeckt wird. Mit einer solchen Anordnung ist die Gesenkbiegepresse besonders einfach bedienbar.

Bevorzugt weist die Strahlenquelle mehrere, parallel zueinander verlaufende Strahlen auf, wobei einzelne der Strahlen ausblendbar sind. Dadurch kann der von diesem Zustimmschalter überwachte Bereich in einen aktiven Teilbereich und in einen passiven Teilbereich aufgeteilt werden. In diesem Zusammenhang kann unter dem Ausblenden ein Ausschalten oder aber auch ein Inaktiv-Setzen verstanden werden, so dass die Steuerung ein Unterbrechen der ausgeblendeten Strahlen ignoriert und trotzdem einen Arbeitshub der Gesenkbiegepresse auslöst.

Vorzugsweise sind die Strahlenquelle und der Strahlenempfänger vor der Unterwange, auf deren dem Bediener zugewandten Seite angeordnet, womit der Zustimmschalter vor der Gesenkbiegepresse angeordnet ist. Eine derartige Anordnung gewährleistet eine einfache Bedienung der Gesenkbiegepresse und eine sichere Zugänglichkeit des Zustimmschalters. Bei einer Gesenkbiegepresse, die einen integrierten Fussraum aufweist, sind die Strahlenquelle sowie der Strahlenempfänger für eine einfache Zugänglichkeit des Zustimmschalters vorteilhaft innerhalb dieses Fussraums vorgesehen.

Bevorzugt entspricht der Abstand der Strahlenquelle relativ zu dem Strahlenempfänger zumindest der Länge eines in der Unterwange und/oder in der Oberwange angeordneten Werkzeugs, so dass entlang des gesamten zur Verfügung stehenden Arbeitsbereichs der Arbeitshub einfach auslösbar ist.

Vorzugsweise ist der Abstand der Strahlenquelle zu dem Strahlenempfänger einstellbar, womit die Position des Zustimmschalters flexibel an die Bedürfnisse, insbesondere an die Bedürfnisse des Bedieners, angepasst werden kann.

Bevorzugt ist der Abstand der Strahlenquelle und/oder des Strahlenempfängers relativ zu einer von der Unterwange aufgespannten Ebene einstellbar, um die Position des Zustimmschalters flexibel an die Bedürfnisse, insbesondere an die Bedürfnisse des Bedieners, anpassen zu können. Vorteilhaft sind die Strahlenquelle und der Strahlenempfänger nur gleichzeitig beziehungsweise gemeinsam relativ zu der Unterwange einstellbar, womit verhindert wird, dass die Strahlung der Strahlenquelle aufgrund unterschiedlicher Abstände der Strahlenquelle und des Strahlenempfängers relativ zu der von der Unterwange aufgespannten Ebene nicht mehr oder nur noch ungenügend von dem Strahlenempfänger erfasst wird.

Vorzugsweise ist an der Gesenkbiegepresse zumindest ein Auflagetisch mit einer Blechauflagefläche vorgesehen und die Strahlenquelle sowie der Strahlenempfänger sind in einem Bereich an der der Blechauflagefläche abgewandten Seite des Auflagetischs angeordnet, womit der Zustimmschalter einfach und sicher bedienbar ist.

Bevorzugt sind an der Gesenkbiegepresse zumindest zwei Auflagearme vorgesehen, wobei die Strahlenquelle an einem der Auflagearme, an dessen dem anderen Auflagearm zugewandten Seite angeordnet ist und der Strahlenempfänger an dem anderen Auflagearm, an dessen dem anderen Auflagearm zugewandten Seite angeordnet ist, womit der Zustimmschalter einfach und sicher bedienbar ist. Vorteilhaft sind die zumindest zwei Auflagearme relativ zueinander positionierbar, so dass der Betätigungsbereich des Zustimmschalters bedarfsweise anpassbar ist.

Vorzugsweise ist die Strahlenquelle oder der Strahlenempfänger über eine Funkverbindung mit einer Steuerung der Gesenkbiegepresse verbunden, womit eine Verkabelung der Strahlenquelle oder des Strahlenempfängers sich erübrigt. Besonders vorteilhaft sind die Strahlenquelle oder der Strahlenempfänger beide über eine Funkverbindung mit der Steuerung der Gesenkbiegepresse verbunden. Vorteilhaft kommt eine sichere Funkverbindung zur Anwendung, welche den entsprechenden Vorschriften entspricht. Die Funkverbindung darf insbesondere nicht einfach ausfallen und darf nicht verfälschbar sein. Als ein nicht abschliessendes Beispiel sei hier eine Funkverbindung in Form einer Bluetooth®-Funkverbindung genannt.

Bevorzugt ist zumindest ein zweiter Zustimmschalter vorgesehen, so dass der Bediener in Abhängigkeit seiner Position relativ zu der Gesenkbiegepresse und/oder des zu bearbeitenden Blechstücks den für ihn dann idealen Zustimmschalter zur Ausübung des Arbeitshubs betätigen kann. Der zumindest eine zweite Zustimmschalter ist beispielsweise als Fusspedalschalter ausgebildet.

Alternativ kann der zumindest eine zweite Zustimmschalter ebenfalls eine Strahlenquelle und einen Strahlenempfänger umfassen und damit gegebenenfalls gleichartig wie der erste Zustimmschalter ausgebildet sein.

Bei einer Ausgestaltung der Gesenkbiegepresse mit mehr als einem Zustimmschalter werden diese vorteilhaft derart miteinander verschaltet, dass diese sich gegenseitig deaktivieren beziehungsweise sich übersteuern können.

Das im Anspruch 11 dargelegte, erfindungsgemässe Verfahren zur Betätigung einer Gesenkbiegepresse umfasst die Schritte:
a) Verfahren zumindest der Oberwange relativ zu der Unterwange und Anhalten der Verfahrbewegung zumindest der Oberwange in einer Stellung, in welcher keine Gefahr für den Bediener ausgeht;
b) Unterbrechen der Strahlung zwischen der Strahlenquelle und dem Strahlenempfänger des Zustimmschalters;
c) Ausüben des Arbeitshubs der Gesenkbiegepresse;
d) Verfahren zumindest der Oberwange relativ zu der Unterwange in eine Stellung, in welcher keine Gefahr für den Bediener ausgeht.

Dieses erfindungsgemässe Verfahren gewährleistet eine einfache Bedienung der Gesenkbiegepresse bei gleichzeitig ausreichender Gewährleistung der Bediensicherheit.

Mit dem Schritt a) wird sichergestellt, dass keine für den Bediener gefahrbringende Bewegung möglich ist.

Das Ausüben des Arbeitshubs (Schritt c)) erfolgt vorteilhaft erst nach einem gewissen Zeitraum nach dem die Strahlung unterbrochen wurde (Schritt b)). Damit wird sichergestellt, dass dem Bediener ausreichend Zeit zur Positionierung seiner Extremitäten ausserhalb des Arbeitsbereichs der Werkzeuge der Gesenkbiegepresse verbleibt.

Die im Schritt d) genannte Stellung muss nicht zwingend mit der im Schritt a) genannten Stellung übereinstimmen. Für einen optimierten Arbeitsablauf könnte dies jedoch vorteilhaft sein.

Vorteilhaft erfolgt der Schritt d) automatisch, gesteuert durch die Steuerung der Gesenkbiegepresse.

Vorzugsweise wird vor dem Ausüben des Arbeitshubs (Schritt c)) und nach dem Unterbrechen der Strahlung (Schritt b)) die Strahlung zwischen der Strahlenquelle und dem Strahlenempfänger des Zustimmschalters freigegeben, wobei der Arbeitshub der Gesenkbiegepresse erst nach dem Freigeben der Strahlung ausgeübt wird (Schritt c)). Mit dieser Massnahme wird die Sicherheit des Bedieners noch zusätzlich verbessert.

Bevorzugt wird vor dem Verfahren zumindest der Oberwange relativ zu der Unterwange (Schritt a)) die Strahlung zwischen der Strahlenquelle (und dem Strahlenempfänger unterbrochen, wobei das Verfahren zumindest der Oberwange relativ zu der Unterwange (Schritt a)) erst nach dem Unterbrechen ausgeübt wird. Mit diesem Verfahrensschritt wird bereits die Inbetriebnahme der Gesenkbiegepresse erst mittels des Zustimmschalters ermöglicht.

Optional wird das Verfahren zumindest der Oberwange relativ zu der Unterwange (Schritt a)) erst nach dem Unterbrechen und nach einem Freigeben der Strahlung ausgeübt, womit die Sicherheit des Bedieners weiter verbessert wird.

Ein alternatives, erfindungsgemässes Verfahren, wie im Anspruch 14 dargelegt, umfasst die Schritte:
a) Verfahren zumindest der Oberwange relativ zu der Unterwange und Anhalten der Verfahrbewegung zumindest der Oberwange in einer Stellung, in welcher keine Gefahr für den Bediener ausgeht;
b) Einführen des Werkstücks zwischen die Oberwange und die Unterwange;
c) Unterbrechen der Strahlung zwischen der Strahlenquelle und dem Strahlenempfänger des Zustimmschalters, wobei das Unterbrechen der Strahlung durch das Werkstück und/oder durch den Bediener erfolgt;
d) Freigeben der Strahlung zwischen der Strahlenquelle und dem Strahlenempfänger des Zustimmschalters;
e) Ausüben des Arbeitshubs der Gesenkbiegepresse;
f) Verfahren zumindest der Oberwange relativ zu der Unterwange in eine Stellung, in welcher keine Gefahr für den Bediener ausgeht, wobei das Verfahren vorteilhaft automatisch erfolgt.

Mit dem Schritt a) wird sichergestellt, dass keine für den Bediener gefahrbringende Bewegung möglich ist.

Vorteilhaft wird die Strahlung während oder nach dem Einführen des Werkstücks zwischen die Oberwange und die Unterwange unterbrochen (Schritt c)). Anschliessend wird das Werkstück in einen Bereich der Gesenkbiegepresse überführt, der nicht vom aktiven Strahlungsbereich des Zustimmschalters abgedeckt ist. Dadurch wird die Strahlung zwischen der Strahlenquelle und dem Strahlenempfänger des Zustimmschalters freigegeben (Schritt d)).

Die Unterbrechung und Freigabe der Strahlung zwischen der Strahlenquelle und dem Strahlenempfänger des Zustimmschalters kann auch durch den Bediener, z. B. mit einem seiner Körperteile, erfolgen.

Das Ausüben des Arbeitshubs (Schritt e)) erfolgt vorteilhaft erst nach einem gewissen Zeitraum nach dem die Strahlung unterbrochen wurde (Schritt c)). Damit wird sichergestellt, dass dem Bediener ausreichend Zeit zur Positionierung seiner Extremitäten ausserhalb des Arbeitsbereichs der Werkzeuge der Gesenkbiegepresse verbleibt.

Die im Schritt f) genannte Stellung muss nicht zwingend mit der im Schritt a) genannten Stellung übereinstimmen. Für einen optimierten Arbeitsablauf könnte dies jedoch vorteilhaft sein.

Vorteilhaft erfolgt der Schritt f) automatisch, gesteuert durch die Steuerung der Gesenkbiegepresse.

Neben den vorgenannten Verfahrensschritten ist es weiter denkbar, weitere oder andere Verfahrensschritten im Betrieb der Gesenkbiegepresse abhängig von einer vorgängigen Betätigung des zumindest einen Zustimmschalters zu steuern.

Vorzugsweise wird die Strahlung zwischen der Strahlenquelle und dem Strahlenempfänger des Zustimmschalters von einem Körperteil eines Bedieners unterbrochen beziehungsweise freigegeben, was eine einfache und sichere Betätigung des Zustimmschalters durch den Bediener ermöglicht. Vorteilhaft wird zur Unterbrechung beziehungsweise Freigabe der Strahlung ein Fuss und/oder eine Hand des Bedieners verwendet.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein.

Die Bezugszeichenliste ist wie auch der technische Inhalt der Patentansprüche und Figuren Bestandteil der Offenbarung. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

Es zeigen dabei:
- Fig. 1: eine Ausführungsform einer erfindungsgemässen Gesenkbiegepresse in einer Frontansicht,
- Fig. 2: eine schematische Seitenansicht einer Unterwange mit Zustimmschalter einer weiteren Ausführungsform einer erfindungsgemässen Gesenkbiegepresse,
- Fig. 3: die schematische Seitenansicht der Unterwange gemäss Fig. 2 mit unterbrochenem Zustimmschalter,
- Fig. 4: eine weitere Ausführungsform einer erfindungsgemässen Gesenkbiegepresse in einer Frontansicht; und
- Fig. 5: eine weitere Ausführungsform einer erfindungsgemässen Gesenkbiegepresse in einer perspektivischen Darstellung.

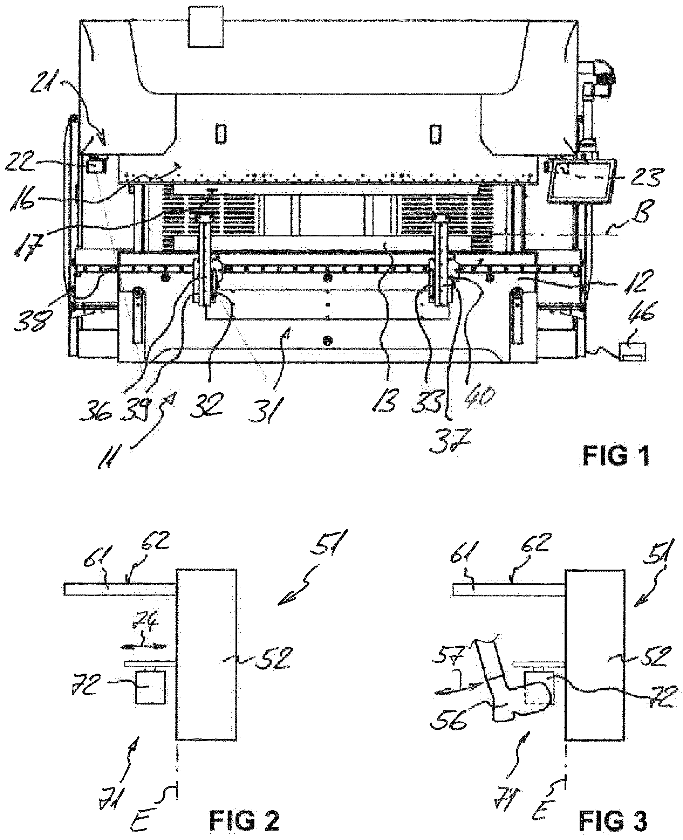

Die Figur 1 zeigt eine Gesenkbiegepresse 11 mit einer Unterwange 12, in die ein Werkzeug 13 angeordnet ist, und mit einer Oberwange 16, in der ein Werkzeug 17 angeordnet ist. Die Oberwange 16 ist relativ zu der Unterwange 12 verfahrbar.

Die Gesenkbiegepresse 11 weist weiter eine Schutzeinrichtung 21 zur Sicherung eines Gefahrenbereichs zwischen der Unterwange 12 und der Oberwange 16 auf. Die Schutzeinrichtung 21 ist als eine optische Schutzeinrichtung, vorzugsweise als eine Lichtschranke ausgebildet und umfasst einen Sender 22 und einen dem Sender 22 gegenüberliegenden Empfänger 23. Weiter ist diese Schutzeinrichtung 21 mitfahrend ausgebildet. Im vorliegenden Beispiel ist die Schutzeinrichtung 21 relativ zur Oberwange 16 sowie zusammen mit dieser verfahrbar, so dass die Schutzeinrichtung 21 den Bereich zwischen den Werkzeugen 13 und 17 beziehungsweise zwischen der Unterwange 12 und der Oberwange 16 abdecken kann. Befindet sich der Sender 22 und der Empfänger 23 der Schutzeinrichtung 21 in der vorgenannten Position, wird jedes Teil, das zwischen den Werkzeugen 13 und 17 liegt oder zu liegen kommt, von dieser erkannt. Ein Verfahren der Oberwange 16 in Richtung der Unterwange 12 wird soweit unterbunden, dass keine zwischen den Werkzeugen 13 und 17 beziehungsweise zwischen der Unterwange 12 und der Oberwange 16 befindlichen Extremitäten des Bedieners gequetscht werden.

Die daraus resultierende Schutzwirkung der Schutzeinrichtung 21 ist mittels eines von einem Bediener betätigbaren Zustimmschalters 31 überwindbar. Der Zustimmschalter 31 umfasst eine Strahlenquelle 32 und einen Strahlenempfänger 33, wobei die Strahlenquelle 32 und der Strahlenempfänger 33 Teil einer Lichtschranke sind. Anstelle einer Lichtschranke können die Strahlenquelle 32 und der Strahlenempfänger 33 Teil eines Lichtgitters sein.

Die Strahlenquelle 32 ist eine Quelle für elektromagnetische Strahlung, vorzugsweise eine Lichtquelle, und der Strahlenempfänger 33 ist ein Detektor für elektromagnetische Strahlung, vorzugsweise eine Kamera, ein CCD-Chip oder einzelne Fotodioden.

Die Strahlenquelle 32 und der Strahlenempfänger 33 sind bei der Unterwange 12, auf deren dem Bediener zugewandten Seite angeordnet. Die Strahlrichtung der Strahlenquelle 32 verläuft entlang der, hier parallel zur Biegelinie B der Gesenkbiegepresse 11. Die Biegelinie B entspricht einer Linie, die parallel zu der Längserstreckung der Unterwange 12 beziehungsweise der Oberwange 16 verläuft.

An der Gesenkbiegepresse 11 sind zwei Auflagearme 36 und 37 vorgesehen, die relativ zueinander positionierbar sind. Die Auflagearme 36 und 37 sind beispielsweise entlang einer Führungsschiene 38 verschiebbar und mittels einer Klemm- und/oder Halteeinrichtung 39 bzw. 40 in einer bestimmten Position lösbar fixierbar. Die Strahlenquelle 32 ist an dem Auflagearm 36, an dessen dem anderen Auflagearm 37 zugewandten Seite angeordnet und der Strahlenempfänger 33 ist an dem anderen Auflagearm 37, an dessen dem anderen Auflagearm 36 zugewandten Seite angeordnet. Dadurch ist der Abstand der Strahlenquelle 32 relativ zu dem Strahlenempfänger 33 einstellbar.

Der Strahlenempfänger 33 ist beispielsweise über eine Funkverbindung mit einer Steuerung der Gesenkbiegepresse 11 verbunden. Auch die Strahlenquelle 32 kann über eine Funkverbindung mit der Steuerung der Gesenkbiegepresse 11 verbunden sein.

An der Gesenkbiegepresse 11 ist ein zweiter Zustimmschalter 46 vorgesehen. Der zweite Zustimmschalter 46 ist hier als Fusspedalschalter ausgebildet und ermöglicht es dem Bediener, in Abhängigkeit der jeweiligen Situation während den Bearbeitungsgängen den für ihn ideal zugänglichen Zustimmschalter 31 oder 46 zu wählen, um die Schutzwirkung der Schutzeinrichtung 21 zu überwinden beziehungsweise diese zu übersteuern.

Zur Betätigung der erfindungsgemässen Gesenkbiegepresse 11 und Biegen eines Werkstücks, z. B. eines Blechs, wird die Oberwange 16 z. B. von ihrem Totpunkt relativ zu der Unterwange 12 verfahren. Dieses geschieht, indem die Strahlung zwischen der Strahlenquelle 32 und dem Strahlenempfänger 33 unterbrochen und wieder freigegeben wird. Der Bediener benutzt dazu beispielsweise eines seiner Körperteile, wie z. B. seinen Fuss oder sein Bein. Es besteht die Möglichkeit die Oberwange 16 in einer Stellung anzuhalten, in welcher keine Gefahr für den Bediener ausgeht (Schritt a)). In dieser Stellung (auch Sicherheitspunkt genannt) weisen die Werkzeuge 13 und 17 relativ zueinander einen Abstand auf, der derart gross ist, dass der Bediener weder seine Finger noch seine die Hand dazwischen einklemmen kann beziehungsweise dass diese dazwischen gequetscht werden. Der Hub kann jetzt mit dem Zustimmschalter 31 oder dem Fusspedal 46 fortgesetzt werden.

Dann wird der Arbeitshub der Gesenkbiegepresse 11 ausgeübt, da nun die Schutzeinrichtung 21 von der Steuerung der Gesenkbiegepresse 11 übersteuert und somit die Schutzwirkung der Schutzeinrichtung 21 überwunden wird (Schritt c)). Dabei wird der gewünschte Biegevorgang an dem zu biegenden Werkstück ausgeführt.

Vorteilhaft wird vor dem Ausüben des Arbeitshubs (Schritt c)) und nach dem Unterbrechen der Strahlung (Schritt b)) die Strahlung zwischen der Strahlenquelle 32 und dem Strahlenempfänger 33 des Zustimmschalters 31 freigegeben, wobei der Arbeitshub der Gesenkbiegepresse 11 erst nach dem Freigeben der Strahlung ausgeübt wird (Schritt c)).

Anschliessend wird die Oberwange 16 von der Unterwange 12 weg in eine Stellung (entweder zum Sicherheitspunkt oder in den beziehungsweise zu dem Totpunkt der Oberwange 16) vor dem Verfahren zumindest der Oberwange (16) relativ zu der Unterwange (12; 52; 82) (Schritt a)) die Strahlung zwischen der Strahlenquelle (32; 72; 92) und dem Strahlenempfänger (33; 93) unterbrochen und optional wieder freigegeben wird, wobei das Verfahren zumindest der Oberwange (16) relativ zu der Unterwange (12; 52; 82) (Schritt a)) erst nach dem Unterbrechen und optional nach dem Freigeben der Strahlung ausgeübt wird. verfahren, in welcher wieder keine Gefahr für den Bediener ausgeht (Schritt d)). Diese Stellung der Oberwange 16 kann der Stellung entsprechen, in welcher sich die Oberwange 16 nach der Durchführung des Schritt a) befindet. Vorteilhaft erfolgt das Verfahren der Oberwange 16 nach Beendigung des Arbeitshubs automatisch, gesteuert von der Steuerung der Gesenkbiegepresse 11.

In einer Variante muss vor dem Verfahren der Oberwange 16 relativ zu der Unterwange 12 (Schritt a)) der Zustimmschalter 31 betätigt werden. Somit muss vor der Durchführung des Schritts a) die Strahlung zwischen der Strahlenquelle 32 und dem Strahlenempfänger 33 unterbrochen und I wieder freigegeben werden.

Wie schematisch in den Figuren 2 und 3 gezeigt ist an dieser Gesenkbiegepresse 51 ein Auflagetisch 61 mit einer Blechauflagefläche 62 vorgesehen. Die Strahlenquelle 72 sowie der Strahlenempfänger des Zustimmschalters 71 sind in einem Bereich an der der Blechauflagefläche 62 abgewandten Seite des Auflagetischs 61 angeordnet.

Der Abstand der Strahlenquelle 72 sowie des Strahlenempfängers des Zustimmschalters 71 sind relativ zu einer von der Unterwange 52 aufgespannten Ebene E einstellbar (in die Richtungen des Doppelpfeils 74).

Die Strahlung zwischen der Strahlenquelle 72 und dem Strahlenempfänger des Zustimmschalters 71 wird von dem Fuss 56 des Bedieners unterbrochen beziehungsweise freigegeben (siehe Fig. 3; in die Richtungen des Doppelpfeils 57).

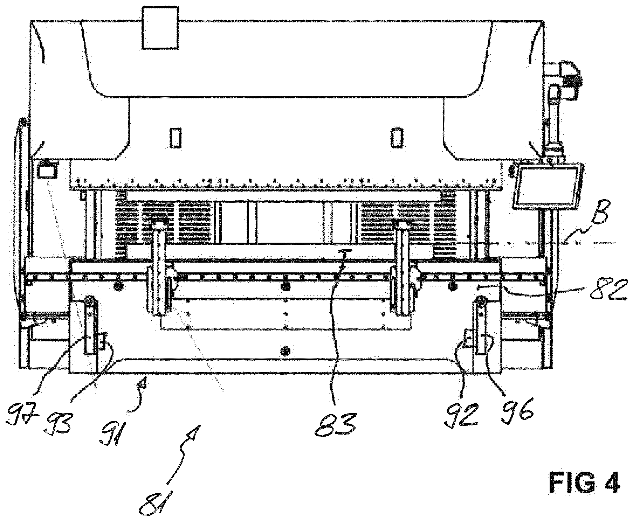

Die in der Figur 4 gezeigte Variante einer Gesenkbiegepresse 81 entspricht im Wesentlichen der Ausgestaltung der in Zusammenhang mit der Figur 1 beschriebenen Gesenkbiegepresse 11, wobei jedoch der Zustimmschalter 91 anders angeordnet ist. Auch der Zustimmschalter 91 umfasst eine Strahlenquelle 92 und einen Strahlenempfänger 93, die einander zugewandt sind. Der Abstand der Strahlenquelle 92 zu dem Strahlenempfänger 93 ist grösser als die Länge eines in der Unterwange 82 der Gesenkbiegepresse 81 angeordneten Werkzeugs 83.

An der Unterwange 82 sind zwei Führungselemente 96 bzw. 97 vorgesehen. Entlang dem Führungselement 96, das beispielsweise als Führungsschiene ausgebildet ist, ist die Strahlenquelle 92 relativ zu der Biegelinie B beziehungsweise zum Werkzeug 83 verschiebbar. Entlang dem Führungselement 97, das beispielsweise auch als Führungsschiene ausgebildet ist, ist der Strahlenempfänger 93 relativ zu der Biegelinie B beziehungsweise zum Werkzeug 83 verschiebbar. Vorteilhaft ist ein Verschiebemechanismus vorgesehen, über den die Strahlenquelle 92 und der Strahlenempfänger 93 synchron relativ zu der Biegelinie B beziehungsweise zum Werkzeug 83 positioniert werden. Zur Fixierung der Strahlenquelle 92 an dem Führungselement 96 und des Strahlenempfängers 93 an dem Führungselement 97 in der gewünschten Position ist ein gemeinsamer oder jeweils ein separater Klemm- oder Haltemechanismus vorgesehen.

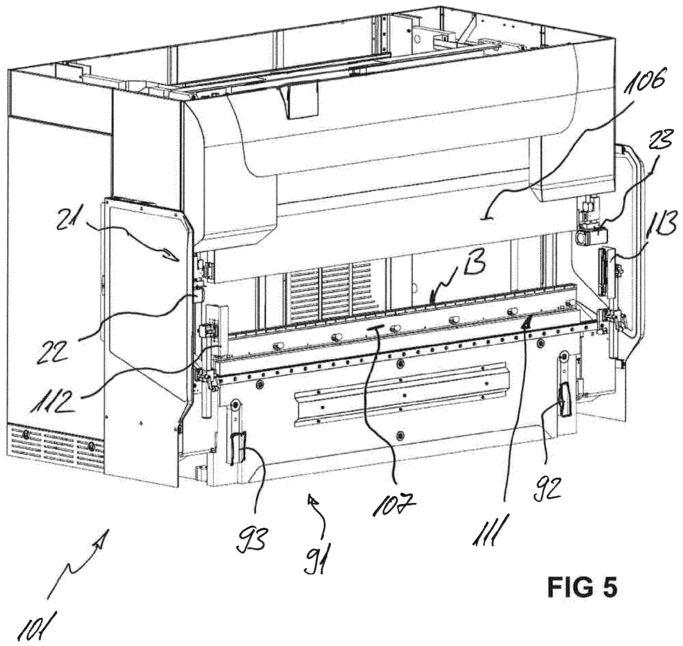

Die in der Figur 5 gezeigte Variante einer Gesenkbiegepresse 101 entspricht ebenfalls im Wesentlichen der Ausgestaltung der in Zusammenhang mit der Figur 1 beschriebenen Gesenkbiegepresse 11 beziehungsweise der der in Zusammenhang mit der Figur 4 beschriebenen Gesenkbiegepresse 81, wobei jedoch der Zustimmschalter 111 anders angeordnet ist. Auch der Zustimmschalter 111 umfasst eine Strahlenquelle 112 und einen Strahlenempfänger 113, die einander zugewandt sind.

Die Strahlenquelle 112 weist mehrere, parallel zueinander verlaufende Strahlen auf, wobei einzelne der Strahlen ausblendbar sind. Vorteilhaft werden die Strahlen der Strahlenquelle 112 zumindest vor dem auslösen des Arbeitshubs der Gesenkbiegepresse 101 ausgeblendet, welche im Bereich der Biegelinie B liegen.

An der Gesenkbiegepresse 101 ist ein zweiter Zustimmschalter 91 vorgesehen. Der zweite Zustimmschalter 91 ist wie der im Zusammenhang mit der Figur 4 beschriebenen Zustimmschalter 91 ausgebildet und bedienbar. Die beiden Zustimmschalter 91 und 111 ermöglichen es dem Bediener, in Abhängigkeit der jeweiligen Situation während den Bearbeitungsgängen den für ihn ideal zugänglichen beziehungsweise einfach bedienbaren Zustimmschalter 91 oder 111 zu wählen, um die Schutzwirkung der Schutzeinrichtung 21 zu überwinden beziehungsweise diese zu übersteuern.

Zur Betätigung der Gesenkbiegepresse 101 wird die Oberwange 106 relativ zu der Unterwange verfahren und die Verfahrbewegung der Oberwange 106 in einer Stellung angehalten, in welcher keine Gefahr für den Bediener ausgeht. Dann wird das Werkstücks zwischen die Oberwange 106 und die Unterwange eingeführt und zwar derart, dass die Strahlung zwischen der Strahlenquelle 112 und dem Strahlenempfänger 113 des Zustimmschalters 111 unterbrochen wird.

In einer ersten Variante wird das Werkstück nun auf dem an der Unterwange angeordneten Werkzeug 107 aufgelegt. Entweder wird dieser Bereich von dem Zustimmschalter 111 nicht überwacht oder die in diesem Bereich vorhandenen Strahlen der Strahlenquelle 112 werden ausgeblendet. Damit wird die Strahlung zwischen der Strahlenquelle 112 und dem Strahlenempfänger 113 des Zustimmschalters 111 wieder freigegeben.

Durch die Freigabe der Strahlung des Zustimmschalters 111 wird eine Blockierung des Arbeitshubs der Gesenkbiegepresse 101 aufgehoben und der Arbeitshub der Gesenkbiegepresse 101 nun ausgeübt.

Anschliessend wird die Oberwange 106 wieder relativ zu der Unterwange in eine Stellung verfahren, in welcher keine Gefahr für den Bediener ausgeht, wobei das Verfahren vorteilhaft automatisch erfolgt.

In einer zweiten Variante wird das Werkstücks zwischen die Oberwange 106 und die Unterwange eingeführt und zwar derart, dass die Strahlung zwischen der Strahlenquelle 112 und dem Strahlenempfänger 113 des Zustimmschalters 111 unterbrochen wird. Nun führt der Bediener zumindest eines seiner Körperteile, z. B. seine Hand, ebenfalls in einen Bereich ein, der von der Strahlung des Zustimmschalters 111 abgesichert ist. Dieses neben dem Werkstück zusätzlich im Strahlungsbereich des Zustimmschalters 111 befindliche Körperteil wird von diesem detektiert. Wird dieser Körperteil nun aus dem vorgenannten Bereich entfernt, interpretiert die Steuerung der Gesenkbiegepresse 101 diese Bewegung als eine Freigabe der Strahlung des Zustimmschalters 111, worauf der Arbeitshub der Gesenkbiegepresse 101 ausgeübt wird.

In einer Variation dieser Variante wird bei der Entnahme des bearbeiteten Werkstücks aus der Gesenkbiegepresse 101 die Strahlung des Zustimmschalters 111 durch ein zwischen die Oberwange 106 und die Unterwange eingeführtes Körperteil, z. B. eine Hand, des Bedieners unterbrochen. Beim Einführen eines weiteren, zu bearbeitenden Werkstücks wird die Strahlung des Zustimmschalters 111 erneut von einem Körperteil, z. B. eine Hand, des Bedieners unterbrochen, so dass nach dem Rückzug des Körperteils des Bedieners die damit verbundene Bewegung von der Steuerung der Gesenkbiegepresse 101 als Freigabe der Strahlung des Zustimmschalters 111 interpretiert wird.

In einer weiteren, jedoch nicht abschliessenden Alternative wird nach dem Einführen des Werkstücks zwischen die Oberwange 106 und die Unterwange der zweite Zustimmschalter 91 der Gesenkbiegepresse 101 durch Unterbrechen und Freigabe der Strahlung zwischen der Strahlenquelle 92 und dem Strahlenempfänger 93 die Steuerung der Gesenkbiegepresse 101 angewiesen, den Arbeitshub der Gesenkbiegepresse 101 auszuführen. Ein solches Verfahren ist besonders bei Werkstücken vorteilhaft, welche vor dem auszuführenden Biegevorgang bereits mit Abkantungen oder Abbiegungen versehen sind.

**Bezugszeichenliste**

| | | | |
|---|---|---|---|
| 11 | Gesenkbiegepresse | 61 | Auflagetisch |
| 12 | Unterwange | 62 | Blechauflagefläche v. 61 |
| 13 | Werkzeug in 12 | 71 | Zustimmschalter |
| 16 | Oberwange | 72 | Strahlenquelle |
| 17 | Werkzeug in 16 | 74 | Doppelpfeil |
| 21 | Schutzeinrichtung | | |
| 22 | Sender v. 21 | | |
| 23 | Empfänger v. 21 | 81 | Gesenkbiegepresse |
| | | 82 | Unterwange |
| 31 | Zustimmschalter | 83 | Werkzeug in 82 |
| 32 | Strahlenquelle | | |
| 33 | Strahlenempfänger | 91 | Zustimmschalter |
| | | 92 | Strahlenquelle |
| 36 | Auflagearm | 93 | Strahlenempfänger |
| 37 | Auflagearm | | |
| 38 | Führungsschiene f. 36/37 | 96 | Führungselement f. 92 |
| 39 | Klemm-/Halteeinrichtung 32 | 97 | Führungselement f. 93 |
| 40 | Klemm-/Halteeinrichtung 33 | | |
| 46 | 2. Zustimmschalter | 101 | Gesenkbiegepresse |
| B | Biegelinie | 106 107 | Oberwange Werkzeug |
| E | Ebene v. 52 | 111 | Zustimmschalter |
| 51 | Gesenkbiegepresse | 112 | Strahlenquelle |
| 52 | Unterwange | 113 | Strahlenempfänger |
| 56 | Fuss Bediener | | |
| 57 | Doppelpfeil | | |

## Patentansprüche

1. Gesenkbiegepresse mit einer Unterwange (12; 52; 82), einer Oberwange (16), wobei zumindest die Oberwange (16) relativ zu der Unterwange (12; 52; 82) verfahrbar ist, und mit einer Schutzeinrichtung (21) zur Sicherung eines Gefahrenbereichs der Gesenkbiegepresse (11; 51; 81; 101), wobei die Schutzwirkung der Schutzeinrichtung (21) mittels eines von einem Bediener betätigbaren Zustimmschalters (31, 46; 71; 91) überwindbar ist, der Zustimmschalter (31; 71; 91) eine Strahlenquelle (32; 72; 92) und einen Strahlenempfänger (33; 93) umfasst, **dadurch gekennzeichnet, dass** die Strahlrichtung der Strahlenquelle (32; 72; 92; 112) des Zustimmschalters (31; 71; 91; 111) in einer Richtung entlang der, vorzugsweise parallel zur, Biegelinie (B) der Gesenkbiegepresse (11; 51; 81; 101) verläuft.

2. Gesenkbiegepresse nach Anspruch 1, **dadurch gekennzeichnet, dass** die Strahlenquelle (112) und der Strahlenempfänger (113) an der Biegelinie (B) der Gesenkbiegepresse (11; 51; 81; 101) angeordnet sind.

3. Gesenkbiegepresse nach Anspruch 1 oder 2, **dadurch gekennzeichnet, dass** die Strahlenquelle (32; 72; 92; 112) mehrere, parallel zueinander verlaufende Strahlen aufweist, wobei einzelne der Strahlen ausblendbar sind.

4. Gesenkbiegepresse nach einem der Ansprüche 1 bis 3, **dadurch gekennzeichnet, dass** die Strahlenquelle (32; 72; 92; 112) und der Strahlenempfänger (33; 93; 113) bei der Unterwange (12; 52; 82), auf deren dem Bediener zugewandten Seite angeordnet sind.

5. Gesenkbiegepresse nach einem der Ansprüche 1 bis 4, **dadurch gekennzeichnet, dass** der Abstand der Strahlenquelle (92) zu dem Strahlenempfänger (93) zumindest der Länge eines in der Unterwange (82) und/oder in der Oberwange angeordneten Werkzeugs (83) entspricht oder der Abstand der Strahlenquelle (32) relativ zu dem Strahlenempfänger (33) einstellbar ist.

6. Gesenkbiegepresse nach einem der Ansprüche 1 bis 5, **dadurch gekennzeichnet, dass** der Abstand der Strahlenquelle (72) und des Strahlenempfängers relativ zu einer von der Unterwange (52) aufgespannten Ebene (E) einstellbar ist.

7. Gesenkbiegepresse nach einem der Ansprüche 1 bis 6, **dadurch gekennzeichnet, dass** zumindest ein Auflagetisch (61) mit einer Blechauflagefläche (62) vorgesehen ist und die Strahlenquelle (72) sowie der Strahlenempfänger in einem Bereich an der der Blechauflagefläche (62) abgewandten Seite des Auflagetischs (61) angeordnet sind.

8. Gesenkbiegepresse nach einem der Ansprüche 1 bis 6, **dadurch gekennzeichnet, dass** zumindest zwei Auflagearme (36, 37) vorgesehen sind, die vorteilhaft relativ zueinander positionierbar sind, wobei die Strahlenquelle (32) an einem der Auflagearme (36), an dessen dem anderen Auflagearm (37) zugewandten Seite angeordnet ist und der Strahlenempfänger (33) an dem anderen Auflagearm (37), an dessen dem anderen Auflagearm (36) zugewandten Seite angeordnet ist.

9. Gesenkbiegepresse nach einem der Ansprüche 1 bis 8, **dadurch gekennzeichnet, dass** die Strahlenquelle (32) und/oder der Strahlenempfänger (33) über eine Funkverbindung mit einer Steuerung der Gesenkbiegepresse (11) verbunden ist bzw. sind.

10. Gesenkbiegepresse nach einem der Ansprüche 1 bis 9, **dadurch gekennzeichnet, dass** ein zweiter Zustimmschalter (46; 101) vorgesehen ist, der vorteilhaft eine Strahlenquelle (102) und einen Strahlenempfänger (103) umfasst.

11. Verfahren zur Betätigung einer Gesenkbiegepresse (11; 51; 81; 101) nach einem der Ansprüche 1 bis 10 umfassend die Schritte:
a) Verfahren zumindest der Oberwange (16) relativ zu der Unterwange (12; 52; 82) und Anhalten der Verfahrbewegung zumindest der Oberwange (16) in einer Stellung, in welcher keine Gefahr für den Bediener ausgeht;
b) Unterbrechen der Strahlung zwischen der Strahlenquelle (32; 72; 92; 112) und dem Strahlenempfänger (33; 93; 113) des Zustimmschalters (31; 71; 91; 101);
c) Ausüben des Arbeitshubs der Gesenkbiegepresse (11; 51; 81; 101);
d) Verfahren zumindest der Oberwange (16) relativ zu der Unterwange (12; 52; 82) in eine Stellung, in welcher keine Gefahr für den Bediener ausgeht, wobei das Verfahren vorteilhaft automatisch erfolgt.

12. Verfahren nach Anspruch 11, **dadurch gekennzeichnet, dass** vor dem Ausüben des Arbeitshubs (Schritt c)) und nach dem Unterbrechen der Strahlung (Schritt b)) des Zustimmschalters (31; 71; 91; 111) die Strahlung zwischen der Strahlenquelle (32; 72; 92; 112) und dem Strahlenempfänger (33; 93; 113) des Zustimmschalters (31; 71; 91; 111) freigegeben wird, wobei der Arbeitshub der Gesenkbiegepresse (11; 51; 81; 101) erst nach dem Freigeben der Strahlung ausgeübt wird (Schritt c)).

13. Verfahren nach Anspruch 11 oder 12, **dadurch gekennzeichnet, dass** vor dem Verfahren zumindest der Oberwange (16) relativ zu der Unterwange (12; 52; 82) (Schritt a)) die Strahlung zwischen der Strahlenquelle (32; 72; 92; 112) und dem Strahlenempfänger (33; 93; 113) des Zustimmschalters (31; 71; 91; 111) unterbrochen und optional wieder freigegeben wird, wobei das Verfahren zumindest der Oberwange (16) relativ zu der Unterwange (12; 52; 82) (Schritt a)) erst nach dem Unterbrechen und optional nach dem Freigeben der Strahlung ausgeübt wird.

14. Verfahren zur Betätigung einer Gesenkbiegepresse (11; 51; 81; 101) nach einem der Ansprüche 1 bis 10 umfassend die Schritte:
a) Verfahren zumindest der Oberwange (16) relativ zu der Unterwange (12; 52; 82) und Anhalten der Verfahrbewegung zumindest der Oberwange (16) in einer Stellung, in welcher keine Gefahr für den Bediener ausgeht;
b) Einführen des Werkstücks zwischen die Oberwange (16) und die Unterwange (12; 52; 82);
c) Unterbrechen der Strahlung zwischen der Strahlenquelle (32; 72; 92; 112) und dem Strahlenempfänger (33; 93; 113) des Zustimmschalters (31; 71; 91; 111);
d) Freigeben der Strahlung zwischen der Strahlenquelle (32; 72; 92; 112) und dem Strahlenempfänger (33; 93; 113) des Zustimmschalters (31; 71; 91; 111);
e) Ausüben des Arbeitshubs der Gesenkbiegepresse (11; 51; 81; 101);
f) Verfahren zumindest der Oberwange (16) relativ zu der Unterwange (12; 52; 82) in eine Stellung, in welcher keine Gefahr für den Bediener ausgeht, wobei das Verfahren vorteilhaft automatisch erfolgt.

15. Verfahren nach einem der Ansprüche 11 bis 14, **dadurch gekennzeichnet, dass** die Strahlung zwischen der Strahlenquelle (32; 72; 92; 112) und dem Strahlenempfänger (33; 93; 113) des Zustimmschalters (31; 71; 91; 111) von einem Körperteil, vorteilhaft einem Fuss (56) und/oder einer Hand, eines Bedieners unterbrochen beziehungsweise freigegeben wird.

## Claims

1. A press brake with a lower beam (12; 52; 82), an upper beam (16), at least the upper beam (16) being movable relative to the lower beam (12; 52; 82), and with a protective device (21) for securing a danger zone of the press brake (11; 51; 81, 101), the protective effect of the protective device (21) being superable by means of an enabling switch (31, 46; 71; 91) that can be operated by an operator, the enabling switch (31; 71; 91) comprising a radiation source (32; 72; 92) and a radiation receiver (33; 93), **characterised in that** the beam direction of the radiation source (32; 72; 92; 112) of the enabling switch (31; 71; 91; 111) runs in a direction along, preferably in parallel to, the bending line (B) of the press brake (11; 51; 81; 101).

2. The press brake according to claim 1, **characterised in that** the radiation source (112) and the radiation receiver (113) are arranged on the bending line (B) of the press brake (11, 51, 81, 101).

3. The press brake according to claim 1 or 2, **characterised in that** the radiation source (32; 72; 92; 112) has a plurality of beams which run parallel to one another, wherein individual beams can be masked out.

4. The press brake according to one of claims 1 to 3, **characterised in that** the radiation source (32; 72; 92; 112) and the radiation receiver (33; 93; 113) are arranged on the lower beam (12; 52; 82) on the side thereof facing the operator.

5. The press brake according to one of claims 1 to 4, **characterised in that** the distance from the radiation source (92) to the radiation receiver (93) corresponds at least to the length of a tool (83) arranged in the lower beam (82) and/or in the upper beam, or the distance between the radiation source (32) and the radiation receiver (33) can be adjusted.

6. The press brake according to one of claims 1 to 5, **characterised in that** the distance between the radiation source (72) and the radiation receiver is adjustable relative to a plane (E) spanned by the lower beam (52).

7. The press brake according to one of claims 1 to 6, **characterised in that** at least one support table (61) with a sheet metal support surface (62) is provided and the radiation source (72) and the radiation receiver are arranged in a region on the side of the support table (61) facing away from the sheet metal support surface (62).

8. The press brake according to one of claims 1 to 6, **characterised in that** at least two support arms (36, 37) are provided which can advantageously be positioned relative to one another, wherein the radiation source (32) on one of the support arms (36) on the side thereof facing the other support arm (37), and the radiation receiver (33) is arranged on the other support arm (37) on the side thereof facing the other support arm (36).

9. The press brake according to one of claims 1 to 8, **characterised in that** the radiation source (32) and/or the radiation receiver (33) is or are connected via a radio link to a controller of the press brake (11).

10. The press brake according to one of claims 1 to 9, **characterised in that** a second enabling switch (46; 101) is provided, which advantageously comprises a radiation source (102) and a radiation receiver (103).

11. A method for actuating a press brake (11; 51; 81; 101) according to one of claims 1 to 10, comprising the steps:
a) moving at least the upper beam (16) relative to the lower beam (12; 52; 82) and stopping the movement of at least the upper beam (16) in a position in which there is no danger to the operator;
b) interrupting the radiation between the radiation source (32; 72; 92; 112) and the radiation receiver (33; 93; 113) of the enabling switch (31; 71; 91; 101);
c) performing the working stroke of the press brake (11; 51; 81; 101);
d) moving at least the upper beam (16) relative to the lower beam (12; 52; 82) into a position in which there is no danger to the operator, wherein the movement is advantageously carried out automatically.

12. The method according to claim 11, **characterised in that** the radiation between the radiation source (32; 72; 92; 112) and the radiation receiver (33; 93; 113) of the enabling switch (31; 71; 91; 111) is released before the working stroke is performed (step c)) and after the radiation of the enabling switch (31; 71; 91; 111) is interrupted (step b)), wherein the working stroke of the press brake (11; 51; 81; 101) only being performed after the radiation has been released (step c)).

13. The method according to claim 11 or 12, **characterised in that,** before the movement at least of the upper beam (16) relative to the lower beam (12; 52; 82) (step a)), the radiation between the radiation source (32; 72; 92; 112) and the radiation receiver (33; 93; 113) of the enabling switch (31; 71; 91; 111) is interrupted and optionally released again, wherein the movement of at least the upper beam (16) relative to the lower beam (12; 52; 82) (step a)) is only performed after the radiation is interrupted and optionally after the radiation is released.

14. A method for actuating a press brake (11; 51; 81; 101) according to one of claims 1 to 10, comprising the steps:
a) moving at least the upper beam (16) relative to the lower beam (12; 52; 82) and stopping the movement of at least the upper beam (16) in a position in which there is no danger to the operator;
b) inserting the workpiece between the upper beam (16) and the lower beam (12; 52; 82);
c) interrupting the radiation between the radiation source (32; 72; 92; 112) and the radiation receiver (33; 93; 113) of the enabling switch (31; 71; 91; 111);
d) releasing the radiation between the radiation source (32; 72; 92; 112) and the radiation receiver (33; 93; 113) of the enabling switch (31; 71; 91; 111);
e) performing the working stroke of the press brake (11; 51; 81; 101);
f) moving at least the upper beam (16) relative to the lower beam (12; 52; 82) into a position in which there is no danger to the operator, wherein the movement is advantageously carried out automatically.

15. The method according to one of claims 11 to 14, **characterised in that** the radiation between the radiation source (32; 72; 92; 112) and the radiation receiver (33; 93; 113) of the enabling switch (31; 71; 91; 111) is interrupted or released by a body part, advantageously a foot (56) and/or a hand, of an operator.

## Revendications

1. Presse de pliage avec une lame inférieure (12 ; 52 ; 82), une lame supérieure (16), au moins la lame supérieure (16) étant mobile par rapport à la lame inférieure (12 ; 52 ; 82) et avec un dispositif de protection (21) pour sécuriser une zone dangereuse de la presse de pliage (11 ; 51 ; 81, 101), l'effet protecteur du dispositif de protection (21) pouvant être surmonté au moyen d'un interrupteur de validation (31, 46 ; 71 ; 91) pouvant être actionné par un opérateur, l'interrupteur de validation (31 ; 71 ; 91) comprenant une source de rayonnement (32 ; 72 ; 92) et un récepteur de rayonnement (33 ; 93), **caractérisée en ce que** la direction du faisceau de la source de rayonnement (32 ; 72 ; 92 ; 112) de l'interrupteur de validation (31 ; 71 ; 91 ; 111) suit une direction le long de, de préférence parallèle à, la ligne de pliage (B) de la presse de pliage (11 ; 51 ; 81 ; 101).

2. Presse de pliage selon la revendication 1, **caractérisée en ce que** la source de rayonnement (112) et le récepteur de rayonnement (113) sont disposés sur la ligne de pliage (B) de la presse de pliage (11, 51, 81, 101).

3. Presse de pliage selon la revendication 1 ou 2, **caractérisée en ce que** la source de rayonnement (32 ; 72 ; 92 ; 112) comporte une pluralité de faisceaux parallèles entre eux, des faisceaux individuels pouvant être masqués.

4. Presse de pliage selon l'une des revendications 1 à 3, **caractérisée en ce que** la source de rayonnement (32 ; 72 ; 92 ; 112) et le récepteur de rayonnement (33 ; 93 ; 113) pour la lame inférieure (12 ; 52 ; 82), sont agencés du côté faisant face à l'opérateur.

5. Presse de pliage selon l'une des revendications 1 à 4, **caractérisée en ce que** la distance de la source de rayonnement (92) au récepteur de rayonnement (93) correspond au moins à la longueur d'un outil (83) disposé dans la lame inférieure (82) et/ou dans la lame supérieure ou la distance entre la source de rayonnement (32) et le récepteur de rayonnement (33) peut être ajustée.

6. Presse de pliage selon l'une des revendications 1 à 5, **caractérisée en ce que** la distance entre la source de rayonnement (72) et le récepteur de rayonnement est réglable par rapport à un plan (E) traversé par la lame inférieure (52).

7. Presse de pliage selon l'une des revendications 1 à 6, **caractérisée en ce qu'**au moins une table de support (61) avec une surface de support de tôle (62) est prévue et la source de rayonnement (72) et le récepteur de rayonnement sont disposés dans une zone sur le côté de la table de support (61) opposé à la surface de support de tôle (62).

8. Presse de pliage selon l'une des revendications 1 à 6, **caractérisée en ce qu'**au moins deux bras de support (36, 37) sont prévus, qui peuvent avantageusement être positionnés l'un par rapport à l'autre, la source de rayonnement (32) étant disposée sur l'un des bras de support (36), du côté faisant face à l'autre bras de support (37) et le récepteur de rayonnement (33) est disposé sur l'autre bras de support (37), du côté faisant face à l'autre bras de support (36).

9. Presse de pliage selon l'une des revendications 1 à 8, **caractérisée en ce que** la source de rayonnement (32) et/ou le récepteur de rayonnement (33) est ou sont connectés via une liaison radio à un contrôleur de la presse de pliage (11).

10. Presse de pliage selon l'une des revendications 1 à 9, **caractérisée en ce qu'**un deuxième interrupteur de validation (46 ; 101) est prévu, lequel comprend avantageusement une source de rayonnement (102) et un récepteur de rayonnement (103).

11. Procédé pour actionner une presse de pliage (11 ; 51 ; 81 ; 101) selon l'une des revendications 1 à 10, comprenant les étapes consistant à :
a) déplacer au moins la lame supérieure (16) par rapport à la lame inférieure (12 ; 52 ; 82) et arrêter le mouvement d'au moins la lame supérieure (16) en une position dans laquelle il n'y a aucun danger pour l'opérateur ;
b) interrompre le rayonnement entre la source de rayonnement (32 ; 72 ; 92 ; 112) et le récepteur de rayonnement (33 ; 93 ; 113) de l'interrupteur de validation (31 ; 71 ; 91 ; 101) ;
c) exercer la course de travail de la presse de pliage (11 ; 51 ; 81 ; 101) ;
d) déplacer au moins la lame supérieure (16) par rapport à la lame inférieure (12 ; 52 ; 82) en une position dans laquelle il n'y a pas de danger pour l'opérateur, le procédé étant avantageusement effectué automatiquement.

12. Procédé selon la revendication 11, **caractérisé en ce qu'**avant l'exercice de la course de travail (étape c)) et après l'interruption du rayonnement (étape b)) de l'interrupteur de validation (31 ; 71 ; 91 ; 111), le rayonnement entre la source de rayonnement (32 ; 72 ; 92 ; 112) et le récepteur de rayonnement (33 ; 93 ; 113) de l'interrupteur de validation (31 ; 71 ; 91 ; 111) est libéré, la course de travail de la presse-de pliage (11 ; 51 ; 81 ; 101) n'étant exercée qu'après la libération du rayonnement (étape c)).

13. Procédé selon la revendication 11 ou 12, **caractérisé en ce qu'**avant le déplacement d'au moins la lame supérieure (16) par rapport à la lame inférieure (12 ; 52 ; 82) (étape a)), le rayonnement entre la source de rayonnement (32 ; 72 ; 92 ; 112) et le récepteur de rayonnement (33 ; 93 ; 113) de l'interrupteur de validation (31 ; 71 ; 91 ; 111) est interrompu et éventuellement à nouveau libéré, le déplacement d'au moins la lame supérieure (16) par rapport à la lame inférieure (12 ; 52 ; 82) (étape a)) n'étant exercé qu'après l'interruption et éventuellement après la libération du rayonnement.

14. Procédé pour actionner une presse de pliage (11 ; 51 ; 81 ; 101) selon l'une des revendications 1 à 10, comprenant les étapes consistant à :
a) déplacer au moins la lame supérieure (16) par rapport à la lame inférieure (12 ; 52 ; 82) et arrêter le mouvement d'au moins la lame supérieure (16) en une position dans laquelle il n'y a aucun danger pour l'opérateur ;
b) insérer la pièce à travailler entre la lame supérieure (16) et la lame inférieure (12 ; 52 ; 82) ;
c) interrompre le rayonnement entre la source de rayonnement (32 ; 72 ; 92 ; 112) et le récepteur de rayonnement (33 ; 93 ; 113) de l'interrupteur de validation (31 ; 71 ; 91 ; 111) ;
d) libérer le rayonnement entre la source de rayonnement (32 ; 72 ; 92 ; 112) et le récepteur de rayonnement (33 ; 93 ; 113) de l'interrupteur de validation (31 ; 71 ; 91 ; 111) ;
e) exercer la course de travail de la presse de pliage (11 ; 51 ; 81 ; 101) ;
f) déplacer au moins la lame supérieure (16) par rapport à la lame inférieure (12 ; 52 ; 82) en une position dans laquelle il n'y a pas de danger pour l'opérateur, le procédé étant avantageusement effectué automatiquement.

15. Procédé selon l'une des revendications 11 à 14, **caractérisé en ce que** le rayonnement entre la source de rayonnement (32 ; 72 ; 92 ; 112) et le récepteur de rayonnement (33 ; 93 ; 113) de l'interrupteur de validation (31 ; 71 ; 91 ; 111) est interrompu ou libéré par une partie du corps, avantageusement un pied (56) et/ou une main, d'un opérateur.
